# EUROPEAN PATENT APPLICATION

(11) **EP 2 357 159 A1**
(43) Date of publication of application: **17.08.2011**
(21) Application number: 09831952.8
(22) Date of filing: 10.12.2009
(51) Int. Cl.: C03C 8/04, C03C 8/08, C03C 27/10, H01J 9/26, H01L 51/50, H05B 33/04

(54) **SEALING GLASS, GLASS MEMBER HAVING SEALING MATERIAL LAYER, AND ELECTRONIC DEVICE AND METHOD FOR PRODUCING THE SAME**

(30) Priority: 12.12.2008 JP 2008316644
(71) Applicant: Asahi Glass Company Limited, Chiyoda-ku Tokyo 100-8405 (JP)
(72) Inventor: KAWANAMI, Sohei, Tokyo 100-8405 (JP)
(74) Representative: Müller-Boré & Partner Patentanwälte
(86) International application number: PCT/JP2009/070703
(87) International publication number: WO 2010/067848

(57) **Abstract**

The bonding strength to a glass substrate comprising soda lime glass is increased with good reproducibility at a time of laser sealing, to improve the sealing ability and the reliability of an electronic device.

A glass substrate 3 has a sealing region. On the sealing region, a sealing material layer 5 is provided, which is a fired layer of a glass material for sealing containing a sealing glass, a low-expansion filler and a laser absorbent. The sealing glass contains, as represented by mass percentage, from 70 to 90% of Bi₂O₃, from 1 to 20% of ZnO, from 2 to 12% of B₂O₃ and from 10 to 380 ppm of Na₂O. Such a glass substrate 3 and a glass substrate 2 having an element-formed region provided with an electronic element, are laminated, the sealing material layer 5 is irradiated with a laser light 6 to be melted to bond the glass substrates 2 and 3.

## Description

### TECHNICAL FIELD

The present invention relates to a glass material for laser sealing, a glass member provided with a sealing material layer and an electronic device employing such a material, and a process for producing such an electronic device.

### BACKGROUND ART

A flat panel display device (FPD) such as an organic EL (electro-luminescence) display (OELD), a plasma display panel (PDP) or a liquid crystal display device (LCD) has such a structure that a glass substrate for an element having a light-emitting element formed and a glass substrate for sealing are disposed to face each other and the light-emitting element is sealed in a glass package comprising two such glass substrates bonded (Patent Document 1). Further, for a solar cell such as a dye-sensitized solar cell, application of a glass package having a solar cell element (photoelectric conversion element) sealed with two glass substrates has been studied (Patent Document 2).

As a sealing material to seal a space between two glass substrates, a sealing resin or a sealing glass has been used. Since an organic EL (OEL) element or the like is likely to undergo deterioration by water, application of sealing glass excellent in the moisture resistance, etc. is in progress. Since the sealing temperature of the sealing glass is at a level of from 400 to 600°C, properties of an electronic element portion of the OEL element or the like will be deteriorated when heating treatment is conducted by using a conventional firing furnace. Accordingly, it has been attempted that a layer of a glass material for sealing containing a laser absorbent is disposed between sealing regions provided on the peripheral portions of two glass substrates, and the layer of the glass material for sealing is irradiated with a laser light to heat and melt the layer thereby to conduct sealing (Patent Documents 1 and 2).

The sealing by laser irradiation (laser sealing) can suppress thermal influences on the electronic element portion, but it is difficult to sufficiently increase the bonding strength between the sealing layer and glass substrates when a conventional sealing glass (glass frit) is used, and this problem causes a decrease of the reliability of electronic devices such as FPDs or solar cells. As the sealing glass (glass frit) for laser sealing, use of a PbO glass powder, a Bi₂O₃-B₂O₃ glass powder, a SnO-P₂O₅ glass power (refer to Patent Document 3) or a V₂O₅ glass power (refer to Patent Document 1) is being studied. Among these, a Bi₂O₃-B₂O₃ glass powder has a low softening point and provides little influence on the environment or human body, and accordingly, it is a material suitable as a glass frit for laser sealing.

However, it is not possible to sufficiently increase the bonding strength between a sealing layer and glass substrates by simply using a Bi₂O₃-B₂O₃ glass frit to be for heating in a conventional firing furnace, as a glass frit for laser sealing. For example, Patent Documents 4 and 5 disclose a Bi₂O₃-B₂O₃ glass frit to be used for heating in a firing furnace. It is difficult to sufficiently increase the bonding strength to glass substrates by a laser heating process with such a Bi₂O₃-B₂O₃ glass composition. This is considered to be because of the difference in e.g. melting conditions of glass frit between the heating by a firing furnace and laser heating. Particularly, when soda lime glass having a high thermal expansion coefficient is used for glass substrates, the bonding strength between the sealing layer formed by laser sealing and glass substrates tends to be low.

Also in a case of employing alkali-free glass having a low thermal expansion coefficient for glass substrates, the bonding strength tends to be low like the case of soda lime glass.

### PRIOR ART DOCUMENTS

### PATENT DOCUMENTS

- Patent Document 1:: JP-A-2006-524419
- Patent Document 2:: JP-A-2008-115057
- Patent Document 3:: JP-A-2008-059802
- Patent Document 4:: JP-A-2003-128430
- Patent Document 5:: JP-A-2006-137637

### TECHNICAL PROBLEM

It is an object of the present invention to provide a glass material for laser sealing which can increase with good reproducibility the bonding strength to glass substrates comprising soda lime glass or alkali-free glass at a time of laser sealing; a glass member provided with a sealing material layer employing such a glass material; an electronic device having e.g. an improved sealing reliability and an improved mechanical reliability achieved by increasing the bonding strength between the sealing layer and the glass substrates; and a process for producing such an electronic device.

### SOLUTION TO PROBLEM

The glass material for laser sealing according to an embodiment of the present invention contains sealing glass comprising, as represented by mass percentage, from 70 to 90% of Bi₂O₃, from 1 to 20% of ZnO, from 2 to 12% of B₂O₃ and from 10 to 380 ppm of Na₂O. Further, this glass material for laser sealing contains the above sealing glass, a low-expansion filler and a laser absorbent. Here, in the present invention, the composition of the sealing glass is represented by mass% or ppm based on oxides of the respective components.

The glass member provided with a sealing material layer according to an embodiment of the present invention comprises a glass substrate comprising soda lime glass or alkali-free glass and having a sealing region; and a sealing material layer comprising a fired layer of a glass material for sealing containing a sealing glass, a low-expansion filler and a laser absorbent, provided on the sealing region of the glass substrate; wherein the sealing glass comprises, as represented by mass percentage, from 70 to 90% of Bi₂O₃, from 1 to 20% of ZnO, from 2 to 12% of B₂O₃ and from 10 to 380 ppm of Na₂O.

The electronic device according to another embodiment of the present invention comprises a first glass substrate comprising soda lime glass or alkali-free glass and having an element-formed region provided with an electronic element and a first sealing region provided on the outer peripheral side of the element-formed region; a second glass substrate comprising soda lime glass and having a second sealing region corresponding to the first sealing region of the first glass substrate; and a sealing layer comprising a melted-bonded layer of a glass material for sealing containing a sealing glass, a low-expansion filler and a laser absorbent, formed to seal a space between the first sealing region of the first glass substrate and the second sealing region of the second glass substrate while a space is provided on the element-formed region; wherein the sealing glass comprises, as represented by mass percentage, from 70 to 90% of Bi₂O₃, from 1 to 20% of ZnO, from 2 to 12% of B₂O₃ and from 10 to 380 ppm of Na₂O.

The process for producing an electronic device according to another embodiment of the present invention comprises a step of preparing a first glass substrate comprising soda lime glass or alkali-free glass and having an element-formed region provided with an electronic element and a first sealing region provided on the outer peripheral side of the element-formed region; a step of preparing a second glass substrate comprising soda lime glass and having a second sealing region corresponding to the first sealing region of the first glass substrate and a sealing material layer comprising a fired layer of a glass material for sealing containing a sealing glass, a low-expansion filler and a laser absorbent, formed on the second sealing region; a step of laminating the first glass substrate and the second glass substrate via the sealing material layer while a space is formed on the element-formed region; and a step of irradiating the sealing material layer with a laser light through the second glass substrate to melt the sealing material layer thereby to form a sealing layer to seal the space between the first glass substrate and the second glass substrate; wherein the sealing glass comprises, as represented by mass percentage, from 70 to 90% of Bi₂O₃, from 1 to 20% of ZnO, from 2 to 12% of B₂O₃ and from 10 to 380 ppm of Na₂O.

### ADVANTAGEOUS EFFECTS OF INVENTION

The glass material for laser sealing according to the present invention and the glass member provided with a sealing material layer employing such a material, can improve the bonding strength between soda lime glass substrates and a sealing layer at a time of laser sealing with good reproducibility. Further, it is possible to improve the bonding strength between alkali-free glass substrates and the sealing layer at a time of laser sealing with good reproducibility. Accordingly, with the electronic device according to an embodiment of the present invention and the process for producing such a device, it is possible to improve the sealing reliability and mechanical reliability of the electronic device.

### BRIEF DESCRIPTION OF DRAWINGS

Fig. 1 is a cross-sectional view illustrating the constitution of an electronic device according to the embodiment of the present invention.
Fig. 2 is cross-sectional views illustrating the procedure for production of an electronic device according to the embodiment of the present invention.
Fig. 3 is a plan view illustrating a first glass substrate used in the procedure for production of an electronic device shown in Fig. 2.
Fig. 4 is a cross-sectional view along the line A-A in Fig. 3.
Fig. 5 is a plan view illustrating a second glass substrate used in the procedure for production of an electronic device shown in Fig. 2.
Fig. 6 is a cross-sectional view along the line A-A in Fig. 5.

### DESCRIPTION OF EMBODIMENTS

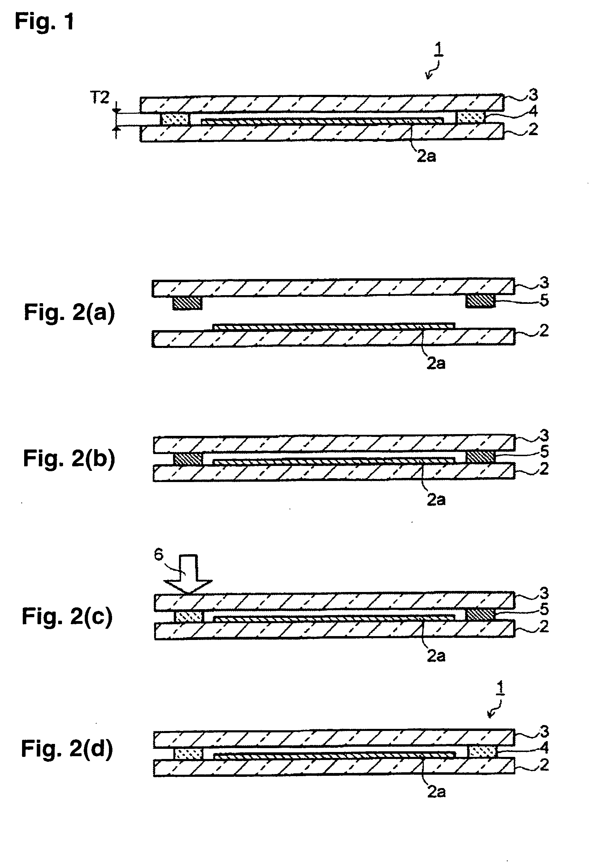

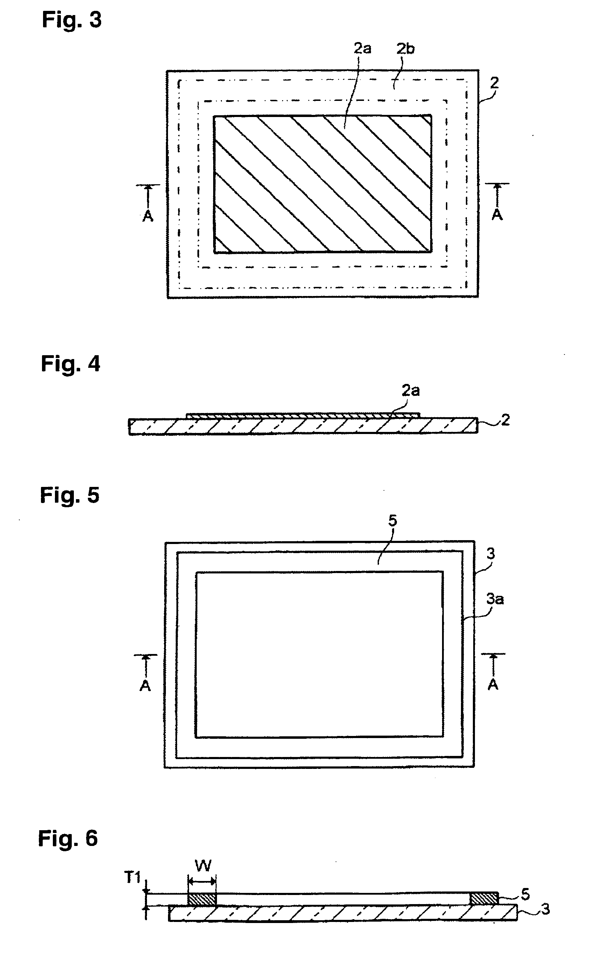

Now, the embodiments of the present invention will be described with reference to drawings. Fig. 1 is a view illustrating the constitution of an electronic device according to the embodiment of the present invention, Fig. 2 is views illustrating the procedure for production of an electronic device, and Figs. 3 and 6 are views illustrating the structures of glass substrates used therefor. An electronic device 1 shown in Fig. 1 constitutes a FPD such as an OELD, a PDP or a LCD, an illumination apparatus employing a light-emitting element such as an OEL element, or a solar cell such as a dye-sensitized solar cell.

An electronic device 1 comprises a first glass substrate (glass substrate for an element) having an element-formed region 2a provided with an electronic element, and a second glass substrate (glass substrate for sealing) 3. The first and the second glass substrates 2, 3 comprise soda lime glass. It is possible to apply various known compositions of soda lime type glass. A soda lime glass usually has a thermal expansion coefficient of about from 85 to 90 × 10⁻⁷/°C. For example, as soda lime glass, AS (manufactured by Asahi Glass Company, Limited), PD200 (manufactured by Asahi Glass Company, Limited) etc. that are commercially available glasses, may be employed. Further, chemically tempered glasses of them may also be employed.

On the element-formed region 2a of the first glass substrate 2, an electronic element depending on the electronic device 1, for example, an OEL element for an OELD or an OEL illumination, a plasma light-emitting element for a PDP, a liquid crystal display element for a LCD, or a dye-sensitized photoelectric conversion part for a solar cell, is formed. Each of electronic elements such as a light emitting element such as an OEL element or a solar cell element such as a dye-sensitized photoelectric conversion part has known structures, and the electronic element is not limited to such an element structure.

The first glass substrate 2 has a first sealing region 2b provided on the outer peripheral side of the element-formed region 2a, as shown in Figs. 3 and 4. The first sealing region 2b is provided so as to surround the element-formed region 2a. The second glass substrate 3 has a second sealing region 3a shown in Figs. 5 and 6. The second sealing region 3a is to correspond to the first sealing region 2b. That is, the first sealing region 2b and the second sealing region 3a are provided so as to face each other when the first glass substrate 2 and the second glass substrate 3 are disposed to face each other, to be a sealing layer 4-formed region (a sealing material layer 5-formed region with respect to the second glass substrate 3) as described hereinafter.

The first glass substrate 2 and the second glass substrate 3 are disposed to face each other to form a space on the element-formed region 2a. The space between the first glass substrate 2 and the second glass substrate 3 are sealed by a sealing layer 4. That is, the sealing layer 4 is formed to seal the space between the sealing region 2b of the first glass substrate 2 and the sealing region 3a of the second glass substrate 3 while a space is provided on the element-formed region 2a. The electronic element formed on the element-formed region 2a is hermetically sealed in a glass panel constituted by the first glass substrate 2, the second glass substrate 3 and the sealing layer 4.

The sealing layer 4 comprises a melt-bonded layer having a sealing material layer 5 formed on the sealing region 3a of the second glass substrate 3 melted by a laser light 6 and bonded on the sealing region 2b of the first glass substrate 2. That is, on the sealing region 3a of the second glass substrate 3 to be used for preparation of the electronic device 1, a sealing material layer 5 in the form of a frame is formed as shown in Figs. 5 and 6. By melt-bonding the sealing material layer 5 formed on the sealing region 3a of the second glass substrate 3 by heat of the laser light 6 on the sealing region 2b of the first glass substrate 2, a sealing layer 4 to seal the space (element-disposed space) between the first glass substrate 2 and the second glass substrate 3 is formed.

The sealing material layer 5 is a fired layer of a glass material for sealing containing a sealing glass (glass frit), a laser absorbent and a low-expansion filler. The glass material for sealing comprises sealing glass as the main component, and a laser absorbent and a low-expansion filler incorporated. The glass material for sealing may contain additives in addition to the above components as the case requires. As the sealing glass (glass material for laser sealing) as the main component of the glass material for sealing, a bismuth glass (Bi₂O₃-B₂O₃ glass) having a composition of from 70 to 90% of Bi₂O₃, from 1 to 20% of ZnO, from 2 to 12% of B₂O₃ and from 10 to 380 ppm of Na₂O as represented by mass percentage, is employed.

The sealing glass for laser sealing (glass frit) is preferably a glass absorbing no laser (transparent glass) from the viewpoint of controlling the melting temperature of the glass. By controlling the melting temperature by the type or the amount, etc. of the laser absorbent added to the sealing glass, it is possible to carry out the laser sealing step with high reliability. Further, the sealing glass (glass frit) preferably has a lower melting temperature from the viewpoint of suppressing thermal shock to the glass substrates 2 and 3. Further, considering the influence on environment or human body, the sealing glass preferably contains no lead and no vanadium etc. A bismuth glass frit meets these requirements.

In the sealing glass (glass frit) employed in this embodiment, a glass constituted by three elements that are Bi₂O₃, ZnO and B₂O₃, has characteristics such as transparency and low glass-transition point, and thus such a glass is suitable as a sealing material for low heating temperature. However, it is not possible to sufficiently increase the bonding strength between the glass substrates 2, 3 and the sealing layer 4 simply by applying the sealing glass containing the above three components to the laser sealing. This is considered to be because of the difference in e.g. melting conditions of glass frit between the heating by a firing furnace and a laser heating.

The bonding strength between the glass substrates and the glass frit, is based on a residual strain caused by thermal expansion difference between these members and an interface reaction between the glass substrates and the glass frit. In a case of applying heating using a common firing furnace, a reacted layer is formed on an interface between each glass substrate and the glass frit (sealing layer) regardless of the type of the glass substrate or the glass frit, which increases the bonding strength by chemical bonding. In other words, in a sealing step using heating by a firing furnace, the heating time is long enough to form a reacted layer on the bonding interface, whereby a sufficient bonding strength can be obtained.

On the other hand, a sealing step using laser heating is carried out by irradiation with a laser light 6 with scanning along the sealing material layer 5 in the form of a frame. The sealing material layer 5 is sequentially melted from a portion irradiated with the laser light 6 and is quenched and solidified upon completion of the irradiation with laser light 6. Thus, it is not possible to obtain a sufficient time for forming a reacted layer in the laser sealing step. Accordingly, it is not possible to sufficiently increase the bonding strength between the glass substrates 2, 3 and the sealing layer 4 at the time of laser sealing with a glass frit constituted by three components that are Bi₂O₃, ZnO and B₂O₃.

In the sealing step using laser heating, in order to form a reacted layer on a bonding interface, it is effective to make the glass frit contain an element easily dispersible into the glass frit, specifically, a monovalent light metal. Particularly, it is effective to make a bismuth glass frit contain Na₂O that is also contained in the composition of glass substrates (soda lime glass composition). By using such a four-component type bismuth glass frit, it becomes possible to increase the bonding strength between the glass substrates 2, 3 and the bismuth glass frit (sealing layer 4) at a time of laser sealing.

That is, by making a bismuth glass frit constituted by three components that are Bi₂O₃, ZnO and B₂O₃, contain a proper amount of Na₂O, even in a laser sealing wherein local melt-solidification of glass frit occurs in a short time, reactivity of a bismuth glass frit with the glass substrates 2 and 3 comprising soda lime glass improves. That is, it is possible to form a reacted layer on a bonding interface even in a laser sealing step. Accordingly, it becomes possible to increase the bonding strength between glass substrate 2, 3 and a bismuth glass frit (sealing layer 4) at a time of laser sealing.

In a sealing glass (a bismuth glass frit) to be employed in this embodiment, Bi₂O₃ is a component for forming glass network, and Bi₂O₃ is contained in an amount of from 70 to 90 mass% in the sealing glass. If the content of Bi₂O₃ is less than 70 mass%, the softening temperature of the glass frit becomes high, and sealing at a low temperature becomes difficult. Further, it becomes necessary to increase the power of the laser light 6 to soften the glass frit, and as a result, e.g. cracks tend to be formed in the glass substrates 2 and 3. If the content of Bi₂O₃ exceeds 90 mass%, vitrification becomes difficult, production of a glass becomes difficult and the thermal expansion coefficient tends to be too high.

ZnO is a component for lowering the thermal expansion coefficient and the softening temperature, and ZnO is contained in an amount of from 1 to 20 mass% in the sealing glass. If the content of ZnO is less than 1 mass%, vitrification becomes difficult. If the content of ZnO exceeds 20 mass%, stability at a time of forming a low melting point glass decreases, whereby devitrification tends to occur and a sealing glass may not be obtained. Considering e.g. the stability of glass production, the content of ZnO is more preferably within a range of from 7 to 12 mass%.

B₂O₃ is a component for expanding a range wherein forming of glass network to achieve vitrification becomes possible, and B₂O₃ is contained in an amount of from 2 to 12 mass% in the sealing glass. If the content of B₂O₃ is less than 2 mass%, vitrification becomes difficult. If the content of B₂O₃ exceeds 12 mass%, the softening point becomes high, whereby the power of the laser light 6 needs to be increased and e.g. cracks may be formed in the glass substrates 2 and 3. Considering e.g. the stability of glass and laser power, the content of B₂O₃ is more preferably within a range of from 5 to 10 mass%.

Na₂O is a component for improving the bonding strength between the glass substrates 2, 3 comprising soda lime glass and a sealing layer 4 (a melt-bonded layer of a sealing material layer 5 containing a sealing glass, a laser absorbent and a low-expansion filler), and Na₂O is contained in an amount of from 10 to 380 ppm as represented by mass percentage in the sealing glass. If the content of Na₂O is less than 10 ppm, the effect of improving bonding strength cannot be sufficiently obtained. On the other hand, if the content of Na₂O exceeds 380 ppm, reaction with e.g. wires formed on the first glass substrate 2 tends to occur at the time of laser sealing.

That is, in a sealing region 2b of the first glass substrate 2, e.g. lead wirings for electrodes of an electronic element formed in an element-formed region 2a are formed. Excessive Na₂O may react with the wirings on the first glass substrate 2 to cause e.g. breakage of the wirings. Further, if the content of Na₂O is too high, the stability of the sealing glass is deteriorated to cause devitrification, whereby a sealing glass may not be obtained. Considering the effect of improving the bonding strength between the glass substrates 2, 3 and the sealing layer 4, the influence on e.g. wirings and the stability of sealing glass etc., the content of Na₂O is more preferably within a range of from 10 to 100 ppm as represented by mass percentage.

In the same manner as the above-mentioned Na₂O, Li₂O and K₂O also function as components for forming a reacted layer on the bonding interface between the glass substrates 2, 3 and the sealing layer 4. However, among these alkaline metal oxides, Na₂O essentially contained in the composition of glass substrates (soda lime glass composition) is particularly effective, and accordingly, the sealing glass of this embodiment contains Na₂O as an essential component. A part of Na₂O may be substituted by at least one member selected from Li₂O and K₂O. The amount of Na₂O substituted by Li₂O or K₂O is preferably at least 50 mass% of the amount of Na₂O considering e.g. formation of a reacted layer on the bonding interface. In a case of substituting Na₂O by Li₂O or K₂O, the content of Na₂O is preferably within a range of from 10 to 190 ppm as represented by mass percentage.

The sealing glass constituted by the above four components has a low glass transition point, and is suitable as a sealing material at low temperature. The sealing glass may contain an optional component such as Al₂O₃, CeO₂, SiO₂, Ag₂O, WO₃, MoO₃, Nb₂O₃, Ta₂O₅, Ga₂O₃, Sb₂O₃, Cs₂O, CaO, SrO, BaO, P₂O₅ or SnOₓ (x is 1 or 2). However, if the content of such optional component is too high, the sealing glass becomes unstable, and devitrification may occur, or the glass transition point or the softening point may become high. Accordingly, the total content of such optional components is preferably at most 10 mass%. The lower limit of the total content of the optional components is not particularly limited. A bismuth glass (glass frit) may contain an optional component in an effective amount according to the type of component.

Among the above optional components, Al₂O₃, SiO₂, CaO, SrO, BaO, etc. are components contributing to stabilization of glass, and its content is preferably within a range of from 0 to 5 mass%. Cs₂O has a function of lowering the softening temperature of a glass, and CeO₂ has an effect of stabilizing the fluidity of a glass. Ag₂O, WO₃, MoO₃, Nb₂O₃, Ta₂O₅, Ga₂O₃, Sb₂O₃, P₂O₅, SnOₓ etc. may be contained as components for adjusting e.g. the viscosity or the thermal expansion coefficient of a glass. The content of these components may be appropriately selected within a range wherein the total content does not exceed 10 mass%.

The glass material for sealing contains a low-expansion filler. The low-expansion filler is preferably at least one member selected from silica, alumina, zirconia, zirconium silicate, cordierite, a zirconium phosphate compound, soda lime glass and a borosilicate glass. As the zirconium phosphate compound, (ZrO)₂P₂O₇, AZr₂(PO₄)₃ (A is at least one member selected from Na, K and Ca), NbZr₂ (PO₄)₃, Zr₂(WO₃)(PO₄)₂ or a complex compound of them may be mentioned. The low-expansion filler is one having a lower thermal expansion coefficient than that of the sealing glass as the main component of the glass material for sealing.

The content of the low-expansion filler is appropriately set so that the thermal expansion coefficient of the sealing glass becomes close to the thermal expansion coefficient of the glass substrates 2 and 3. The low-expansion filler is preferably contained in an amount of from 1 to 50 vol% based on the glass material for sealing depending on the thermal expansion coefficients of the sealing glass and the glass substrates 2 and 3. In this embodiment, since the glass substrates 2 and 3 comprise soda lime glass (thermal expansion coefficient: 85 to 90×10⁻⁷/°C), the low-expansion filler is more preferably contained in an amount of from 15 to 45 vol% based on the glass material for sealing.

The glass material for sealing further contains a laser absorbent. As the laser absorbent, at least one metal selected from Fe, Cr, Mn, Co, Ni and Cu, or a compound such as an oxide containing the above metal, is employed. The content of the laser absorbent is preferably within a range of from 0.1 to 10 vol% based on the glass material for sealing. If the content of the laser absorbent is less than 0.1 vol%, it is not possible to sufficiently melt the sealing material layer 5 at a time of laser irradiation. If the content of the laser absorbent exceeds 10 vol%, a portion of the glass material for sealing in the vicinity of the interface with the second glass substrate 3 may be locally heated by laser irradiation to cause e.g. cracks of the second glass substrate 3, or the flowability of melted glass material for sealing decreases to deteriorate the adhesion to the first glass substrate 2.

The thickness T1 of the sealing material layer 5 is set according to the required space between the first glass substrate 2 and the second glass substrate 3, that is, the thickness T2 of the sealing layer 4. An electronic device 1 and its production process in this embodiment are effective particularly in a case of setting the thickness T1 of the sealing material layer 5 to be at least 10 µm. Even in a case where a sealing material layer 5 having such a thickness T1 is irradiated with a laser light 6 to carry out sealing, it becomes possible to improve e.g. the bonding strength between the glass substrates 2, 3 and the sealing layer 4 and the hermetic sealing property of the glass panel by this embodiment.

The thickness T1 of the sealing material layer 5 is set according to the required space T2 between the first glass substrate 2 and the second glass substrate 3, and in this case, the cross-sectional area represented by the product of the thickness T1 and the line width W of the sealing material layer 5, is preferably at most 15,000 µm². If the cross-sectional area of the sealing material layer 5 exceeds 15,000 µm², it becomes necessary to increase a laser power for softening and flowing the glass material for sealing to carry out bonding, and as a result, e.g. cracks tend to be formed in the glass substrates 2, 3 or the sealing layer 4. Considering the effect of suppressing e.g. cracks due to the laser power, the cross-sectional area of the sealing material layer 5 is more preferably at most 12,000 µm².

The line width W of the sealing material layer 5 is appropriately set depending on the thickness T1 and the cross-sectional area, but if the line width W of the sealing material layer 5 is too small, e.g. the hermetic sealing performance or the bonding reliability of the sealing material layer 4 may decrease. For this reason, the line width W of the sealing material layer 5 is preferably at least 400 µm. Further, the thickness T1 of the sealing material layer 5 is preferably at most 30 µm considering e.g. formation of the sealing layer 4 or the bonding reliability. Further, T1 is preferably at least 1 µm.

The sealing material layer 5 comprising the above-mentioned glass material for sealing, is formed on the sealing region 3a of the second glass substrate 3 by a process such as one described below. First, a glass material for sealing containing a sealing glass (bismuth glass frit), a laser absorbent and a low-expansion filler, is mixed with a vehicle to prepare a sealing material paste.

The vehicle may, for example, be one having methyl cellulose, ethyl cellulose, carboxymethyl cellulose, oxyethyl cellulose, benzyl cellulose, propyl cellulose, nitrocellulose or the like dissolved in a solvent such as terpineol, butyl carbitol acetate or ethyl carbitol acetate, or one having an acrylic resin of e.g. methyl (meth)acrylate, ethyl (meth)acrylate, butyl (meth)acrylate or 2-hydroxyethyl methacrylate dissolved in a solvent such as methyl ethyl ketone, terpineol, butyl carbitol acetate or ethyl carbitol acetate.

The viscosity of the sealing material paste is fitted to the viscosity in accordance with an apparatus which applies the paste on the glass substrate 3, and may be adjusted by the ratio of the resin (binder component) to the solvent or the ratio of the glass material for sealing to the vehicle. To the sealing material paste, known additives for a glass paste, such as an antifoaming agent or a dispersing agent may be added. For preparation of the sealing material paste, a known method employing a rotary mixer equipped with a stirring blade, a roll mill, a ball mill or the like may be applied.

The sealing material paste is applied on the sealing region 3a of the second glass substrate 3, and the paste is dried to form a coating layer of the sealing material paste. The sealing material paste is applied on the second sealing region 3a employing, for example, a printing method such as screen printing or gravure printing, or applied along the second sealing region 3a using a dispenser or the like. The coating layer of the sealing material paste is dried, for example, at a temperature of at least 120°C for at least 10 minutes. The drying step is carried out to remove the solvent in the coating layer. If the solvent remains in the coating layer, the binder component may not sufficiently be removed in the following firing step.

The above coating layer of the sealing material paste is fired to form a sealing material layer 5. In the firing step, first, the coating layer is heated to a temperature of at most the glass transition point of the sealing glass (glass frit) as the main component of the glass material for sealing to remove the binder component in the coating layer, and then heated to a temperature of at least the softening point of the sealing glass (glass frit) to melt the glass material for sealing and burn it on the glass substrate 3. In such a manner, a sealing material layer 5 comprising the glass material for sealing is formed.

Then, as shown in Fig. 2(a), by using the second glass substrate 3 having the sealing material layer 5, and a separately prepared first glass substrate 2 having an element-formed region provided with an electronic element, an electronic device 1 such as a FPD such as an OELD, a PDP or a LCD, an illumination apparatus using an OEL element, or a solar cell such as a dye-sensitized solar cell, is prepared. That is, as shown in Fig. 2(b), the first glass substrate 2 and the second glass substrate 3 are laminated so that a face having the element-formed region 2a and a face having the sealing material layer 5 face each other. On the element-formed region 2a of the first glass substrate 2, a space is formed based on the thickness of the sealing material layer 5.

Then, as shown in Fig. 2(c), the sealing material layer 5 is irradiated with a laser light 6 through the second glass substrate 3. The laser light 6 is applied with scanning along the sealing material layer 5 in the form of a frame. The laser light 6 is not particularly limited, and a laser light from e.g. a semiconductor laser, a carbon dioxide laser, an excimer laser, a YAG laser or a HeNe laser may be employed. The output of the laser light 6 is properly set depending on e.g. the thickness of the sealing material layer 5, and is preferably within a range of from 2 to 150 W for example. If the laser output is less than 2 W, the sealing material layer 5 may not sometimes be melted, and if it exceeds 150 W, the glass substrates 2 and 3 are likely to have cracks, fractures and the like. The output of the laser light is more preferably within a range of from 5 to 100 W.

The sealing material layer 5 is sequentially melted from a portion irradiated with the laser light 6 with scanning along the sealing material layer 5, and is quenched and solidified upon completion of irradiation with the laser light 6, to be bonded on the first glass substrate 2. Then, by irradiating the sealing material layer 5 with the laser light 6 over the perimeter thereof, a sealing layer 4 to seal a space between the first glass substrate and the second glass substrate 3 is formed as shown in Fig. 2(d). At this time, since the sealing glass (bismuth glass frit) contains Na₂O excellent in reactivity with the glass substrate 2 made of soda lime glass, even in a short time melt-solidification step (sealing step) by irradiation with the laser light 6, the adhesion between the glass substrate 2 and the sealing glass improves. Accordingly, it is possible to increase the bonding strength between the glass substrates 2, 3 and the sealing layer 4.

Thus, with a glass panel constituted by the first glass substrate 2, the second glass substrate 3 and the sealing layer 4, an electronic device 1 having an electronic element formed on the element-formed region 2a hermetically sealed, is produced. The reliability of the electronic device 1 depends on e.g. the hermetic sealing property by the sealing layer 4 or the bonding strength between the glass substrates 2, 3 and the sealing layer 4, etc. In this embodiment, since it is possible to increase the hermetic sealing property or the bonding strength, it becomes possible to obtain an electronic device 1 excellent in reliability. The glass panel inside of which is hermetically sealed, can be applied not only to the electronic device 1, but also a sealed body (package) of an electronic component or a glass member (e.g. building material) such as a vacuum double glazing.

As another embodiment wherein alkali-free glass having a thermal expansion coefficient of about from 35 to 40 × 10⁻⁷/°C is employed as the glass substrates 2 and 3 of the electronic device 1, the same effects can be obtained as in the case of using the above soda lime glass. The preferred content of Na₂O in the glass frit in this embodiment is also similar to that of the above case.

As the alkali-free glass, for example, AN100 (manufactured by Asahi Glass Company, Limited), EAGEL2000 (manufactured by Corning Inc.), EAGEL GX (manufactured by Corning Inc.), JADE (manufactured by Corning Inc.), #1737 (manufactured by Corning Inc.), OA-10 (manufactured by Nippon Electric Glass Co., Ltd.) or TEMPAX (manufactured by Schott AG), etc. may be employed.

### EXAMPLES

Now, specific Examples of the present invention and their evaluation results will be described. Here, the following explanations do not limit the present invention, and the present invention can be modified within the gist of the present invention.

### EXAMPLE 1

A bismuth glass frit (softening temperature: 420°C) having a composition comprising, as represented by mass percentage, 82.0% of Bi₂O₃, 6.5% of B₂O₃, 11.0% of ZnO and 0.5% of Al₂O₃ and further containing 18 ppm of Na₂O as represented by mass percentage; a cordierite powder being a low-expansion filler; and a laser absorbent having a composition comprising, as represented by mass percentage 35%of Fe₂O₃, 35% of Cr₂O₃, 20% of Co₂O₃ and 10% of MnO; were prepared. The content of Na₂O was analyzed by ICP. Further, as a binder component, 5 mass% of ethyl cellulose having a viscosity of 45 cps was dissolved in 95 mass% of 2,2,4-trimethyl-1,3pentanediol monoisobutyrate to prepare a vehicle.

85 vol% of the bismuth glass frit, 10 vol% of the cordierite powder and 5 vol% of the laser absorbent were mixed to prepare a glass material for sealing (thermal expansion coefficient: 72×10⁻⁷/°C). 84 mass% of this glass material for sealing was mixed with 16 mass% of the vehicle to prepare a sealing material paste. Subsequently, to a peripheral region of a second glass substrate (dimensions: 100×100×0.55 mmt) comprising soda lime glass (thermal expansion coefficient: 87×10⁻⁷/°C), the sealing material paste was applied by a screen printing method (line width W: 500 µm) and dried at 120°C for 10 minutes. This coating layer was fired at 460°C for 10 minutes to form a sealing material layer having a thickness T1 of 20 µm.

Next, the second glass substrate having the sealing material layer, and a first glass substrate (soda lime glass substrate having the same composition and the same shape as those of the second glass substrate) having an element-formed region (region in which an OEL element was formed) were laminated. Subsequently, the sealing material layer was irradiated with a laser light (semiconductor laser) having a wavelength of 940 nm and a power of 65 W at a scanning rate of 5 mm/s through the second glass substrate, to melt and quench to solidify the sealing material layer, thereby to bond the first glass substrate and the second glass substrate. Thus, an electronic device wherein an element-formed region was sealed in a glass panel, was prepared and it was subjected to property evaluation to be described later.

### EXAMPLES 2 to 6

A sealing material paste was prepared in the same manner as Example 1 except that the composition of bismuth glass frit (including the content of Na₂O), the types of the low-expansion filler and the laser absorbent and their composition ratio were changed to the conditions shown in Table 1. Further, formation of a sealing material layer on the second glass substrate and laser sealing of the first glass substrate and the second glass substrate were carried out in the same manner as in Example 1 except that the above sealing material paste was employed. Thus, an electronic device having an element-formed region sealed in a glass panel, was prepared and it was subjected to property evaluation to be described later.

### EXAMPLES 7 to 9

A sealing material paste was prepared in the same manner as Example 1 except that the material of the glass substrates was changed to alkali-free glass (thermal expansion coefficient: 37×10⁻⁷/°C), and the composition of the bismuth glass frit (including the content of Na₂O), the types of the low-expansion filler and the laser absorbent and their composition ratio were changed to the conditions shown in Table 1. Further, formation of a sealing material layer on the second glass substrate and laser sealing of the first glass substrate and the second glass substrate were carried out in the same manner as Example 1 except that the above sealing material paste was employed. Thus, an electronic device having an element-formed region sealed in a glass panel, was prepared and it was subjected to property evaluation to be described later.

### COMPARATIVE EXAMPLE 1

Preparation of a glass material for sealing, preparation of a sealing material paste, formation of a sealing material layer on the second glass substrate and laser sealing of the first glass substrate and the second glass substrate were carried out in the same manner as Example 1 except that a bismuth glass frit having a composition comprising, as represented by mass percentage, 82.0% of Bi₂O₃, 6.5% of B₂O₃, 11.0% of ZnO and 0.5% of Al₂O₃ and containing 500 ppm of Na₂O as represented by mass percentage, was employed. Thus, an electronic device having an element-formed region sealed in a glass panel, was prepared and it was subjected to property evaluation to be described later.

### COMPARATIVE EXAMPLE 2

A vanadium type glass frit having a composition comprising, as represented by mass percentage, 44.3%of V₂O₃, 35.1 % of Sb₂O₃, 19.7% of P₂O₅, 0.5% of Al₂O₃ and 0.4% of TiO₂; and a cordierite powder being a low expansion filler; were prepared. Further, as a binder component, 4 mass% of nitrocellulose was dissolved in 96 mass% of butyl diglycol acetate to prepare a vehicle.

90 vol% of the vanadium glass frit and 10 vol% of the cordierite powder were mixed to prepare a glass material for sealing (thermal expansion coefficient: 74×10⁻⁷/°C). 73 mass% of the glass material for sealing and 27 mass% of the vehicle were mixed to prepare a sealing material paste. Subsequently, to a peripheral region of a second glass substrate comprising the same soda lime glass as that of Example 1, the sealing material paste was applied by a screen printing method (line width W: 500 µm), and it was dried at 120°C for 10 minutes. This coating layer was fired at 450°C for 10 minutes to form a sealing material layer having a film thickness T1 of 20 µm.

Next, the second glass substrate having a sealing material layer and a first glass substrate (soda lime glass substrate having the same composition and the same shape as those of the second glass substrate) having an element-formed region (region in which an OEL element was formed) were laminated. Subsequently, the sealing material layer was irradiated with a laser light (a semiconductor laser) having a wavelength of 940 nm and a power of 40 W at a scanning rate of 5 mm/s through the second glass substrate, to melt and quench the sealing material layer thereby to bond the first glass substrate and the second glass substrate. Thus, an electronic device having an element-formed region sealed in a glass panel, was prepared and it was subjected to property evaluation to be described later.

Next, with respect to the outer appearance of the glass panel of each of Examples 1 to 6 and Comparative Examples 1 and 2, presence or absence of cracks of glass plates and presence or absence of breakage of wirings were evaluated. The outer appearance was evaluated by observation with an optical microscope. Further, airtightness of each glass panel was measured. The airtightness was evaluated by applying a helium leak test. Further, the bonding strength of glass substrates with the glass material for sealing employed in each of Examples 1 to 6 and Comparative Examples 1 and 2, was measured by a method described below. These measurement and evaluation results are shown in Tables 1 and 2. Tables 1 and 2 also show preparation conditions of glass panels. Each composition ratio of sealing glass in Table 1 is shown under an assumption that the total amount of main components is 100 mass% for convenience, but the amount of Na₂O being a component of slight amount is also included in the total component (100 mass%) of the sealing glass.

The measurement method of the bonding strength of the glass substrates with the glass material for sealing is described below. First, a case where glass substrates comprise soda lime glass will be described.

### STRENGTH MEASUREMENT METHOD A: IN A CASE OF EMPLOYING GLASS SUBSTRATES MADE OF SODA LIME GLASS

In the vicinity of an end of a first glass substrate having a width of 30 mm, the sealing material paste of each Example is applied to form a sealing material layer having a thickness of 60 µm and a line width of 1 mm. The paste coating layer is fired under a suitable condition of each Example. Subsequently, an end portion of the second glass substrate is disposed on the sealing material layer. The second glass substrate is disposed so that the second glass substrate and the first glass substrate are alternately disposed from each other (the first and the second glass substrates are linearly arranged centering the sealing material layer). While they are pressurized with a load of 10 kg, the sealing material layer is irradiated with a laser light having a wavelength of 940 nm at a scanning rate of 10 mm/s to carry out sealing. The power of the laser light is set to a power suitable for each material. One of glass substrates of a bonding strength measurement sample thus prepared, is fixed by a jig, and a portion of the other glass substrate 20 mm from the sealing material layer is pressurized with a speed of 1 mm/min to break the sealing material layer, and a load at which the sealing material layer is broken is defined as the bonding strength.

### STRENGTH MEASUREMENT METHOD B: IN A CASE OF EMPLOYING SODA LIME GLASS FOR GLASS SUBSTRATES

In the vicinity of an end of a first glass substrate having a width of 25 mm, the sealing material paste of each Example is applied to form a sealing material layer having a thickness of 10 µm and a line width of 1 mm. The paste coating layer is fired under a suitable condition of each Example. Subsequently, an end portion of the second glass substrate is disposed on the sealing material layer. The second glass substrate is disposed so that the second glass substrate and the first glass substrate are alternately disposed from each other (the first and the second glass substrates are linearly arranged centering the sealing material layer). While they are pressurized with a load of 10 kg, the sealing material layer is irradiated with a laser light having a wavelength of 940 nm at a scanning rate of 10 mm/s to carry out sealing. The power of the laser light is set to a power suitable for the material of the Example. A bonding strength measurement sample thus prepared is subjected to a three point bending bonding strength test according to JIS K6856 except for the size of the sample, and a load at which the sealing layer is broken or the glass substrate is broken is defined as the bonding strength.

Subsequently, a case where alkali-free glass is employed for glass substrates will be described. In the vicinity of an end of a first glass substrate having a width of 25 mm, the sealing material paste of each Example is applied to form a sealing material layer having a thickness of 10 µm and a line width of 1 mm. The paste coating layer is fired under a suitable condition of each Example. Subsequently, an end portion of the second glass substrate is disposed on the sealing material layer. The second glass substrate is disposed so that the second glass substrate and the first glass substrate are alternately disposed from each other (the first and the second glass substrates are linearly arranged centering the sealing material layer). While they are pressurized with a load of 10 kg, the sealing material layer is irradiated with a laser light having a wavelength of 940 nm at a scanning rate of 10 mm/s to carry out sealing. The power of the laser light is set to a power suitable for the material of each Example. A bonding strength measurement sample thus prepared is subjected to a three point bending bonding strength test according to JIS K6856 except for the size of the sample, and a load at which the sealing layer is broken or the glass substrate is broken is defined as the bonding strength.

**TABLE 1**

| | | Ex. 1 | Ex. 2 | Ex. 3 | Ex. 4 |
|---|---|---|---|---|---|
| Glass substrate | | Soda lime glass | Soda lime glass | Soda lime glass | Soda lime glass |
| Sealing glass (mass%) | Bi₂O₃ | 82.0 | 82.0 | 82.0 | 72.0 |
| | B₂O₃ | 6.5 | 6.5 | 6.5 | 10.0 |
| | ZnO | 11 | 11 | 11 | 9.0 |
| | Al₂O₃ | 0.5 | 0.5 | 0.5 | 0.2 |
| | SiO₂ | - | - | - | 2.8 |
| | BaO | - | - | - | 6.0 |
| | Na (ppm) | 18 | 100 | 350 | 350 |
| Low-expansion filler | | Cordierite | Cordierite | Cordierite | (1) Cordierite +(2) zircon |
| Laser absorbent | | Fe-Cr-Co-Mn-O | Fe-Cr-Co-Mn-O | Fe-Cr-Co-Mn-O | Fe-Mn-Cu-Al-O |
| Glass material for sealing (vol%) | Sealing glass | 85 | 85 | 85 | 94 |
| | Low-expansion filler | 10 | 10 | 10 | (1) 2.5 (2) 2.0 |
| | Laser absorbent | 5 | 5 | 5 | 1.5 |
| Evaluation results | Airtightness | ○ | ○ | ○ | ○ |
| | Bonding strength A (g) | 250 | 310 | 350 | 240 |
| | Bonding strength B (g) | 441 | 520 | 540 | 450 |
| | Wiring breakage | ○ | ○ | ○ | ○ |
| | Substrate crack | ○ | ○ | ○ | ○ |

**TABLE 2**

| | | Ex. 5 | Ex. 6 | Comp. Ex. 1 | Comp. Ex. 2 |
|---|---|---|---|---|---|
| Glass substrate | | Soda lime glass | Soda lime glass | Soda lime glass | Soda lime glass |
| Sealing glass (mass%) | Bi₂O₃ | 81.2 | 85.3 | 82.0 | - |
| | B₂O₃ | 7.2 | 4.9 | 6.5 | - |
| | ZnO | 11.6 | 8.7 | 11.0 | - |
| | Al₂O₃ | - | 0.5 | 0.5 | 0.5 |
| | CeO₂ | - | 0.6 | - | - |
| | V₂O₅ | | | | 44.3 |
| | Sb₂O₃ | | | | 35.1 |
| | P₂O₅ | | | | 19.7 |
| | TiO₂ | - | - | - | 0.4 |
| | Na (ppm) | 50 | 200 | 500 | - |
| Low-expansion filler | | Zircon | Zirconium phosphate | Zirconium phosphate | Zirconium phosphate |
| Laser absorbent | | Fe-Mn-Cu-Al-O | Fe-Cr-Co-Mn-O | Fe-Cr-Co-Mn-O | - |
| Glass material for sealing (vol%) | Sealing glass | 73 | 77.5 | 85 | 90 |
| | Low-expansion filler | 26 | 20 | 10 | 10 |
| | Laser absorbent | 1 | 2.5 | 5 | - |
| Evaluation results | Airtightness | ○ | ○ | ○ | ○ |
| | Bonding strength A (g) | 300 | 250 | 320 | At most 20 |
| | Bonding strength B (g) | 500 | 460 | 600 | |
| | Wiring breakage | ○ | ○ | × | ○ |
| | Substrate crack | ○ | ○ | ○ | ○ |

As apparent from Tables 1 and 2, the glass panels of Examples 1 to 6 are each excellent in outer appearance and airtightness, and have a good bonding strength. On the other hand, in the glass panel of Comparative Example 1 employing a bismuth glass frit containing more than 380 ppm of Na₂O, the bonding strength was good but breakage of wirings was recognized. Further, in the glass panel of Comparative Example 2 employing a conventional vanadium type glass frit, the bonding strength was low and the reliability of the glass panel (electronic device) was poor.

**TABLE 3**

| | | Ex. 7 | Ex. 8 | Ex. 9 |
|---|---|---|---|---|
| Glass substrate | | Alkali-free glass | Alkali-free glass | Alkali-free glass |
| Sealing glass (mass%) | Bi₂O₃ | 82 | 82 | 82 |
| | B₂O₃ | 6.5 | 6.5 | 6.5 |
| | ZnO | 11 | 11 | 11 |
| | Al₂O₃ | 0.5 | 0.5 | 0.5 |
| | SiO₂ | - | - | - |
| | BaO | - | - | - |
| | Na (ppm) | 18 | 100 | 350 |
| Low-expansion filler | | Cordierite | Cordierite | Cordierite |
| Laser absorbent | | Fe-Cr-Co-Mn-O | Fe-Cr-Co-Mn-O | Fe-Cr-Co-Mn-O |
| Glass material for sealing (vol%) | Sealing glass | 85 | 85 | 85 |
| | Low-expansion filler | 10 | 10 | 10 |
| | Laser absorbent | 5 | 5 | 5 |
| Evaluation results | Airtightness | ○ | ○ | ○ |
| | Bonding strength (g) | 817 | 1183 | 1400 |
| | Wiring breakage | ○ | ○ | ○ |
| | Substrate crack | ○ | ○ | ○ |

Further, as apparent from Table 3, each of the glass panels of Examples 7 to 9 is excellent in outer appearance and airtightness, and the bonding strength improves as the amount of Na₂O increases from 10 to 380 ppm.

### EXAMPLES 10 to 14 and REFERENCE EXAMPLES 1 and 2

A glass panel (Example 10) was prepared in the same manner as Example 1 except that the shape of the sealing material layer (thickness T1, line width W and cross-sectional area based on them) were changed to the conditions shown in Table 4. In the same manner, glass panels (Examples 10 to 14) were prepared so that the shapes of the sealing material layers of respective Examples were changed as shown in Table 4. Further, a glass panel of Example 11 was prepared in the same manner as Example 2, and glass panels of Example 12 to 14 were prepared in the same manner as Example 3. In Reference Examples 1 and 2, a sealing material layer having a cross-sectional area of more than 15,000 µm² was applied. With respect to outer appearance of each of these glass panels, presence or absence of cracks of glass substrates and presence or absence of cracks of the sealing material layer, were evaluated. External appearance was evaluated by optical microscopic observation. Further, in the same manner as Example 1, airtightness was evaluated. Table 4 shows these measurement and evaluation results.

**TABLE 4**

| | Glass material for sealing | Sealing material layer | | | Evaluation result | | |
|---|---|---|---|---|---|---|---|
| | | Thickness (µm) | Line width (µm) | Cross-sectional area (µm²) | Air-tightness | Substrate crack | Sealing layer crack |
| Ex. 10 | Ex. 1 | 10 | 1000 | 10000 | ○ | ○ | ○ |
| Ex. 11 | Ex. 2 | 30 | 400 | 12000 | ○ | ○ | ○ |
| Ex. 12 | Ex. 3 | 45 | 200 | 9000 | ○ | ○ | ○ |
| Ex. 13 | Ex. 3 | 90 | 100 | 9000 | ○ | ○ | ○ |
| Ex. 14 | Ex. 3 | 6 | 1400 | 8400 | ○ | ○ | ○ |
| Ref. Ex. 1 | Ex. 1 | 20 | 1000 | 20000 | × | ○ | × |
| Ref. Ex. 2 | Ex. 2 | 45 | 400 | 18000 | × | ○ | × |

As apparent from Table 4, by making the cross-sectional area of the sealing material layer at most 15,000 µm², it is possible to increase the sealing ability and the airtightness of glass panels with good reproducibility. When the cross-sectional area of the sealing material layer exceeds 15,000 µm², it becomes necessary to increase the laser power for softening the glass material for sealing to be flowable, and as a result, cracks tend to be formed in the sealing layer.

### INDUSTRIAL APPLICABILITY

The glass material for laser sealing of the present invention can increase the bonding strength of soda lime glass substrates, the sealing layer and the alkali-free glass material with good reproducibility.

The entire disclosure of Japanese Patent Application No. 2008-316644 filed on December 12, 2008 including specification, claims, drawings and summary is incorporated herein by reference in its entirety.

### REFERENCE SYMBOLS

1: Electronic device, 2: first glass substrate, 2a: element-formed region, 2b: first sealing region, 3: second glass substrate, 3a: second sealing region, 4: sealing layer, 5: sealing material layer, 6: laser light.

## Claims

1. A sealing glass comprising, as represented by mass percentage, from 70 to 90% of Bi₂O₃, from 1 to 20% of ZnO, from 2 to 12% of B₂O₃ and from 10 to 380 ppm of Na₂O.

2. The sealing glass according to Claim 1, which contains at least one member selected from Al₂O₃, CeO₂, SiO₂, Ag₂O, WO₃, MoO₃, Nb₂O₃, Ta₂O₅, Ga₂O₃, Sb₂O₃, Cs₂O, CaO, SrO, BaO, P₂O₅ and SnOₓ (x is 1 or 2) in an amount of at most 10 mass%.

3. A glass material for laser sealing comprising the sealing glass as defined in Claim 1 or 2, a low-expansion filler and a laser absorbent.

4. A glass member provided with a sealing material layer, which comprises a glass substrate comprising soda lime glass and having a sealing region; and a sealing material layer comprising a fired layer of a glass material for sealing containing a sealing glass, a low-expansion filler and a laser absorbent, provided on the sealing region of the glass substrate;
wherein the sealing glass comprises, as represented by mass percentage, from 70 to 90% of Bi₂O₃, from 1 to 20% of ZnO, from 2 to 12% of B₂O₃ and from 10 to 380 ppm of Na₂O.

5. A glass member provided with a sealing material layer, which comprises a glass substrate comprising alkali-free glass and having a sealing region; and a sealing material layer comprising a fired layer of a glass material for sealing containing a sealing glass, a low-expansion filler and a laser absorbent, provided on the sealing region of the glass substrate;
wherein the sealing glass comprises, as represented by mass percentage, from 70 to 90% of Bi₂O₃, from 1 to 20% of ZnO, from 2 to 12% of B₂O₃ and from 10 to 380 ppm of Na₂O.

6. The glass member provided with a sealing material layer according to Claim 4 or 5, wherein the low-expansion filler comprises at least one member selected from silica, alumina, zirconia, zirconium silicate, cordierite, a zirconium phosphate compound,
soda lime glass and borosilicate glass, and the glass material for sealing contains the low-expansion filler in an amount of from 1 to 50 vol%.

7. The glass member provided with a sealing material layer according to any one of Claims 4 to 6, wherein the laser absorbent comprises at least one metal selected from
Fe, Cr, Mn, Co, Ni and Cu, or a compound containing the metals, and the glass material for sealing contains the laser absorbent in an amount of from 0.1 to 10 vol%.

8. The glass member provided with a sealing material layer according to any one of Claims 4 to 7, wherein the sealing glass further contains at least one member selected from Al₂O₃, CeO₂, SiO₂, Ag₂O, WO₃, MoO₃, Nb₂O₃, Ta₂O₅, Ga₂O₃, Sb₂O₃, Cs₂O, CaO, SrO, BaO, P₂O₅ and SnOₓ (x is 1 or 2) in an amount of at most 10 mass%.

9. The glass member provided with a sealing material layer according to any one of Claims 4 to 8, wherein the sealing material layer has a cross-sectional area, that is represented by the product of the thickness and the width, of at most 15,000 µm².

10. An electronic device which comprises a first glass substrate comprising soda lime glass and having an element-formed region provided with an electronic element and a first sealing region provided on the outer peripheral side of the element-formed region;
a second glass substrate comprising soda lime glass and having a second sealing region corresponding to the first sealing region of the first glass substrate; and
a sealing layer comprising a melt-bonded layer of a glass material for sealing containing a sealing glass, a low-expansion filler and a laser absorbent, formed to seal a space between the first sealing region of the first glass substrate and the second sealing region of the second glass substrate while a space is provided on the element-formed region;
wherein the sealing glass comprises, as represented by mass percentage, from 70 to 90% of Bi₂O₃, from 1 to 20% of ZnO, from 2 to 12% of B₂O₃ and from 10 to 380 ppm of Na₂O.

11. An electronic device which comprises a first glass substrate comprising alkali-free glass and having an element-formed region provided with an electronic element and a first sealing region provided on the outer peripheral side of the element-formed region;
a second glass substrate comprising alkali-free glass and having a second sealing region corresponding to the first sealing region of the first glass substrate; and
a sealing layer comprising a melt-bonded layer of a glass material for sealing containing a sealing glass, a low-expansion filler and a laser absorbent, formed to seal a space between the first sealing region of the first glass substrate and the second sealing region of the second glass substrate while a space is provided on the element-formed region;
wherein the sealing glass comprises, as represented by mass percentage, from 70 to 90% of Bi₂O₃, from 1 to 20% of ZnO, from 2 to 12% of B₂O₃ and from 10 to 380 ppm of Na₂O.

12. The electronic device according to Claim 10 or 11, wherein the sealing glass further contains at least one member selected from Al₂O₃, CeO₂, SiO₂, Ag₂O, WO₃, MoO₃, Nb₂O₃, Ta₂O₅, Ga₂O₃, Sb₂O₃, Cs₂O, CaO, SrO, BaO, P₂O₅ and SnOₓ (x is 1 or 2) in an amount of at most 10 mass%.

13. The electronic device according to any one of Claims 10 to 12, wherein the electronic element is an organic EL element or a solar cell element.

14. A process for producing an electronic device, which comprises a step of preparing a first glass substrate comprising soda lime glass and having an element-formed region provided with an electronic element and a first sealing region provided on the outer peripheral side of the element-formed region;
a step of preparing a second glass substrate comprising soda lime glass and having a second sealing region corresponding to the first sealing region of the first glass substrate and a sealing material layer comprising a fired layer of a glass material for sealing containing a sealing glass, a low-expansion filler and a laser absorbent, formed on the second sealing region;
a step of laminating the first glass substrate and the second glass substrate via the sealing material layer while a space is formed on the element-formed region; and
a step of irradiating the sealing material layer with a laser light through the second glass substrate to melt the sealing material layer thereby to form a sealing layer to seal the space between the first glass substrate and the second glass substrate;
wherein the sealing glass comprises, as represented by mass percentage, from 70 to 90% of Bi₂O₃, from 1 to 20% of ZnO, from 2 to 12% of B₂O₃ and from 10 to 380 ppm of Na₂O.

15. A process for producing an electronic device, which comprises a step of preparing a first glass substrate comprising alkali-free glass and having an element-formed region provided with an electronic element and a first sealing region provided on the outer peripheral side of the element-formed region;
a step of preparing a second glass substrate comprising alkali-free glass and having a second sealing region corresponding to the first sealing region of the first glass substrate and a sealing material layer comprising a fired layer of a glass material for sealing containing a sealing glass, a low-expansion filler and a laser absorbent, formed on the second sealing region;
a step of laminating the first glass substrate and the second glass substrate via the sealing material layer while a space is formed on the element-formed region; and
a step of irradiating the sealing material layer with a laser light through the second glass substrate to melt the sealing material layer thereby to form a sealing layer to seal the space between the first glass substrate and the second glass substrate;
wherein the sealing glass comprises, as represented by mass percentage, from 70 to 90% of Bi₂O₃, from 1 to 20% of ZnO, from 2 to 12% of B₂O₃ and from 10 to 380 ppm of Na₂O.

16. The process for producing an electronic device according to Claim 13 or 15, wherein the sealing glass further contains at least one member selected from Al₂O₃, CeO₂, SiO₂, Ag₂O, WO₃, MoO₃, Nb₂O₃, Ta₂O₅, Ga₂O₃, Sb₂O₃, Cs₂O, CaO, SrO, BaO, P₂O₅ and SnOₓ (x is 1 or 2) in an amount of at most 10 mass%.

17. The process for producing an electronic device according to any one of Claims 14 to 16, wherein the sealing material layer has a cross-sectional area, as represented by the product of the thickness and the width, of at most 15,000 µm².

18. The process for producing an electronic device according to any one of Claims 14 to 17, wherein the electronic element is an organic EL element or a solar cell element.
